(19) Europäisches Patentamt
European Patent Office
Office européen des brevets

(11) **EP 1 399 709 B1**

(12) **EUROPÄISCHE PATENTSCHRIFT**

(45) Veröffentlichungstag und Bekanntmachung des Hinweises auf die Patenterteilung:
**02.04.2008 Patentblatt 2008/14**

(21) Anmeldenummer: **02745135.0**

(22) Anmeldetag: **12.06.2002**

(51) Int Cl.:
*G01B 9/02* (2006.01)     *H01L 31/101* (2006.01)

(86) Internationale Anmeldenummer:
**PCT/DE2002/002135**

(87) Internationale Veröffentlichungsnummer:
**WO 2003/004965 (16.01.2003 Gazette 2003/03)**

(54) **PHOTOSENSOR FÜR EIN DURCHLICHTVERFAHREN ZUR DETEKTION DER BEWEGUNGSRICHTUNG VON INTENSITÄTSMAXIMA UND INTENSITÄTSMINIMA EINER OPTISCHEN STEHENDEN WELLE**

PHOTOSENSOR FOR A TRANSMITTED LIGHT METHOD USED FOR DETECTING THE DIRECTION OF MOVEMENT OF INTENSITY MAXIMA AND INTENSITY MINIMA OF AN OPTICAL STANDING WAVE

PHOTODETECTEUR UTILISE DANS UN PROCEDE FAISANT APPEL A LA TRANSMISSION DE LUMIERE POUR LA DETECTION DU SENS DE DEPLACEMENT DE MAXIMA D'INTENSITE ET DE MINIMA D'INTENSITE D'UNE ONDE OPTIQUE STATIONNAIRE

(84) Benannte Vertragsstaaten:
**AT BE CH CY DE DK ES FI FR GB GR IE IT LI LU MC NL PT SE TR**

(30) Priorität: **29.06.2001 DE 10131608**

(43) Veröffentlichungstag der Anmeldung:
**24.03.2004 Patentblatt 2004/13**

(73) Patentinhaber: **Forschungszentrum Jülich GmbH 52425 Jülich (DE)**

(72) Erfinder:
• **KNIPP, Dietmar
  53773 Hennef (DE)**
• **STIEBIG, Helmut
  52382 Niederzier (DE)**
• **BÜCHNER Hans-Joachim
  98693 Ilmenau-Unterpörlitz (DE)**
• **JÄGER, Gerd
  98693 Ilmenau (DE)**

(74) Vertreter: **Kayser, Christoph et al
Sächsische Straße 1
10707 Berlin (DE)**

(56) Entgegenhaltungen:
| | |
|---|---|
| **EP-A- 0 622 856** | **WO-A-99/12205** |
| **US-A- 4 441 789** | **US-A- 5 389 797** |
| **US-A- 5 414 282** | **US-A- 6 013 912** |

**Beschreibung**

Die vorliegende Erfindung betrifft einen Photosensor für ein Durchlichtverfahren zur Detektion einer Bewegungsrichtung der Intensitätsmaxima und der Intensitätsminima in einem Intensitätsprofil, mit einem transparenten Träger, mit zwei dem Träger zugeordneten ersten Halbleiterelementen und mit wenigstens drei Kontakten.

Auf dem Gebiet der photoelektrischen Detektion optischer Strahlung werden Photosensoren nach den unterschiedlichsten Funktionsprinzipien benutzt, z.B. als Photowiderstände, Photodioden, Phototransistoren oder dergleichen. Gemeinsam ist allen Bauformen, daß die optische Strahlung im Auflichtverfahren detektiert wird. Typische Anwendungsgebiete für solche Photosensoren sind z.B. Lichtschranken oder Überwachungs- und Sicherungsanlagen.

Ein anderes sehr spezielles Anwendungsgebiet der photoelektrischen Detektion sind optische Interferometer. Ein typisches und für technische Längenmessungen häufig angewendetes Ausführungsbeispiel ist das Michelson-Interferometer, bei welchem ein Lichtstrahl an einer Teilereinheit in zwei Teilstrahlen geteilt wird, die nach ihrer Teilung unterschiedliche Wege durchlaufen und nach Rückkehr zur Teilerschicht dort wieder vereinigt werden. Gemäß dem Stand der Technik werden aus der am Interferometerausgang erzeugten Differenzstruktur photoelektrisch zwei Signale mit einer gegenseitigen Phasenverschiebung von 90° zur Erkennung der Bewegungsrichtung des Meßspiegels abgeleitet. In Übereinstimmung mit allen oben genannten anderen photoelektrischen Anwendungen erfolgt die Detektion der Strahlung ebenfalls im Auflicht.

Im Gegensatz dazu breiten sich bei Ausbildung einer optischen stehenden Welle die beiden die Interferenz erzeugenden Strahlen in entgegen gesetzten Richtungen aus. Aus diesem Grunde kann die technische Nutzung und Auswertung des Ergebnisses der Interferenz einer optischen stehenden Welle photoelektrisch nur im Durchlicht erfolgen.

Aus DE 33 00 369 und US 4 443 107 sind Anordnungen für ein Stehende-Wellen-Interferometer bekannt. Entsprechend den Anforderungen an Interferometer zur automatischen Erkennung der Bewegungsrichtung des Meßspiegels sind jeweils zwei Photosensoren vorgesehen, die zwei Signale mit einer gegenseitigen Phasenverschiebung von 90° zur Erkennung der Bewegungsrichtung des Meßspiegels erzeugen. Die Photosensoren sind auf einem Glassubstrat aufgetragen, dessen Dicke durch die Methoden der optischen Präzisionsbearbeitung auf wenige Nanometer genau bearbeitet werden muß, um die 90°-Phasenverschiebung möglichst genau einzuhalten. Dafür ist ein hoher technologischer Aufwand erforderlich, der mit hohen Kosten verbunden ist.

Aus DE 36 12 221 ist bekannt, zwischen die beiden Photosensoren ein piezoelektrisch aktives Bauelement einzubringen und den Abstand zwischen den Sensoren einstellbar zu machen. Durch diese Lösung ist zwar der technologische Aufwand erheblich reduziert, es ist aber immer noch notwendig, etwa bei Temperaturänderungen, etwaige Abstandsänderungen zwischen den Sensoren zu erkennen und den Abstand nachzuregln.

Das Dokument US 6,013,912 beschreibt einen Photosensor mit zwei photoempfindlichen Zonen.

Das Dokument US 4,441,789 beschreibt einen Sensor mit Halbleiterschichten, die eine feste Phasenbeziehung zwischen Wellenlänge und Schichtdicke aufweisen.

Die Aufgabe der vorliegenden Erfindung ist daher, einen Photosensor zu realisieren, bei dem die Einstellung der Phasenlage zwischen zwei Photosensoren kostengünstig in den halbleitertechnologischen Prozeßablauf integriert ist und deshalb mit hoher Genauigkeit vorgenommen werden kann und die Beeinflussung der Phasenlage durch äußere Einflüsse, wie z.B. Änderungen der Umgebungstemperatur, auf eine nicht relevante Größe reduziert werden.

Die Aufgabe wird durch die kennzeichnenden Merkmale des Anspruchs 1.

Durch die gemeinsame Anordnung von wenigstens zwei Halbleiterelementen gemeinsam auf einem Substrat entfällt die aufwendige Justierung der transparenten Photosensoren. Bei zwei auf einem gemeinsamen transparenten Substrat hergestellten transparenten Photosensoren befindet sich zwischen den photoelektrisch aktiven Schichten der beiden transparenten Photosensoren eine bestimmte Anzahl 1 von im wesentlichen transparenten Schichten mit unterschiedlichen Funktionen.

Wird nun mittels eines Lasers und eines Planspiegels eine optische stehende Welle erzeugt und dieses Substrat mit den beiden transparenten Photosensoren auf der optischen Achse der stehenden Welle angeordnet, derart, daß die transparenten Photosensoren in Richtung der optischen Achse hintereinander angeordnet sind, breitet sich die stehende Welle durch das Substrat, die beiden transparenten Photosensoren und durch die Funktionsschichten hindurch aus. Ausgehend von der photoelektrisch aktiven Schicht der transparenten Photosensoren ergibt sich eine entsprechende Periodenlänge von:

modifiziert

$$p = \frac{1}{\lambda} \bullet \sum_{j=1}^{l} d_j n_j$$

wobei λ die Wellenlänge der verwendeten kohärenten Strahlung, 1 die Anzahl der verwendeten Halbleiterschichten zwischen den photoelektrisch aktiven Schichten, d die Schichtdicke und n der Brechungsindex der im wesentlichen photoelektrisch inaktiven Schicht ist. Wird die Periodenlänge p so eingestellt, daß sie der Bedingung

modifiziert

$$p = \frac{k}{8} \cdot \frac{d_{S1} n_{S1}}{2\lambda} - \frac{d_{S2} n_{S2}}{2\lambda} \text{ mit } k = 1,3,5,....$$

genügt, dann besteht bei einer Verschiebung des Planspiegels zwischen den von den photoelektrisch aktiven Schichten der transparenten Photosensoren erzeugten photoelektrischen Signale eine gegenseitige Phasenverschiebung von 90° bzw. ein ungerade ganzzahliges Vielfaches von 90°.

Ein gemeinsames Merkmal der transparenten Photosensoren ist, daß sie in Abhängigkeit des Intensitätsprofils in einer stehenden Welle einen Photostrom erzeugen. Hierbei gilt als optimale Detektionsbedingung für den Photostrom, daß die Schichtdicke der photoelektrisch aktiven Schicht des transparenten Photosensors

$$d < \frac{\lambda}{4 \bullet n}$$

beträgt, wobei die λ die Wellenlänge und n der Brechungsindex der photoelektrisch aktiven Schicht ist.

Weitere Vorteile ergeben sich aus den Merkmalen der Unteransprüche 4 bis 15.

Eine Ausführungsform der vorliegenden Erfindung wird im folgenden anhand der Zeichnungen näher beschrieben. Es zeigen:

Figur 1   ein Diagramm zum schematischen Verlauf einer stehenden Welle durch einen erfindungsgemäßen Photosensor;

Figur 2   eine schematische Ansicht im Schnitt des erfindungsgemäßen Photosensors, bei dem ein Photostrom parallel zur Ausbreitungsrichtung der stehenden Welle fließt; und

Figur 3   eine schematische Ansicht des erfindungsgemäßen Photosensors, bei dem ein Photostrom senkrecht zur Ausbreitungsrichtung der stehenden Welle fließt.

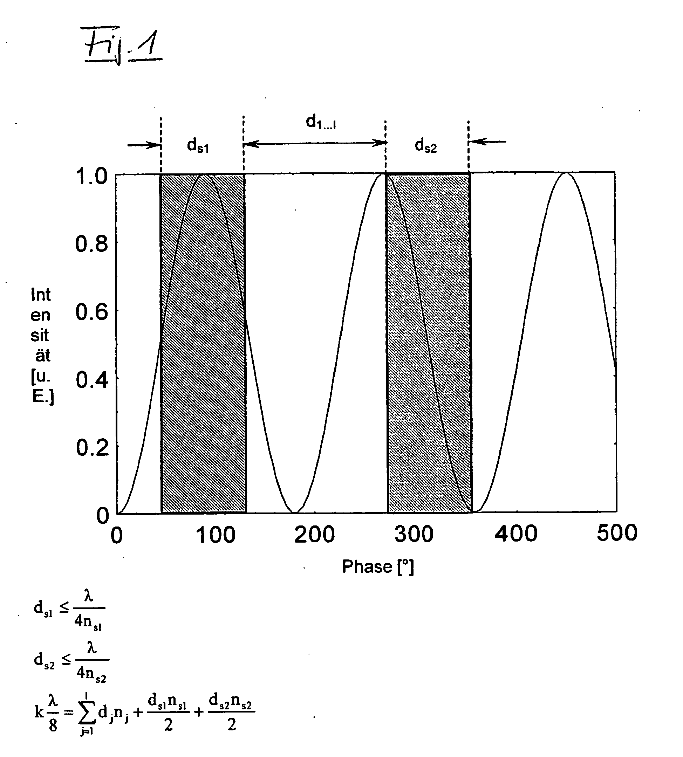

In Figur 1 ist ein Diagramm zum schematischen Verlauf einer stehenden Welle durch einen erfindungsgemäßen Photosensor 1 dargestellt. Die Schichtdicke der photoelektrisch aktiven Schichten ds1 und ds2 beträgt hierbei

$$d_{s1} \leq \frac{\lambda}{4 n_{s1}} \qquad\qquad \text{Gleichung 1}$$

$$d_{s2} \leq \frac{\lambda}{4 n_{s2}} \qquad\qquad \text{Gleichung 2}$$

(der Fall $d_{s1} = \frac{\lambda}{4 n_{s1}}$, $d_{s2} = \frac{\lambda}{4 n_{s2}}$ stellt nur ein Beispiel der und ist nicht Teil der Erfindung)

wobei ns1 und ns2 die Brechungsindizes der photoaktiven Schichten ds1 und ds2 sind. Allgemein läßt sich die Phasenbedingung beschreiben als

modifiziert

$$\sum_{j=1}^{l} n_j d_j = k\frac{\lambda}{8} - \frac{d_{s1}n_{s1}}{2} - \frac{d_{s2}n_{s2}}{2} \qquad \text{Gleichung 3}$$

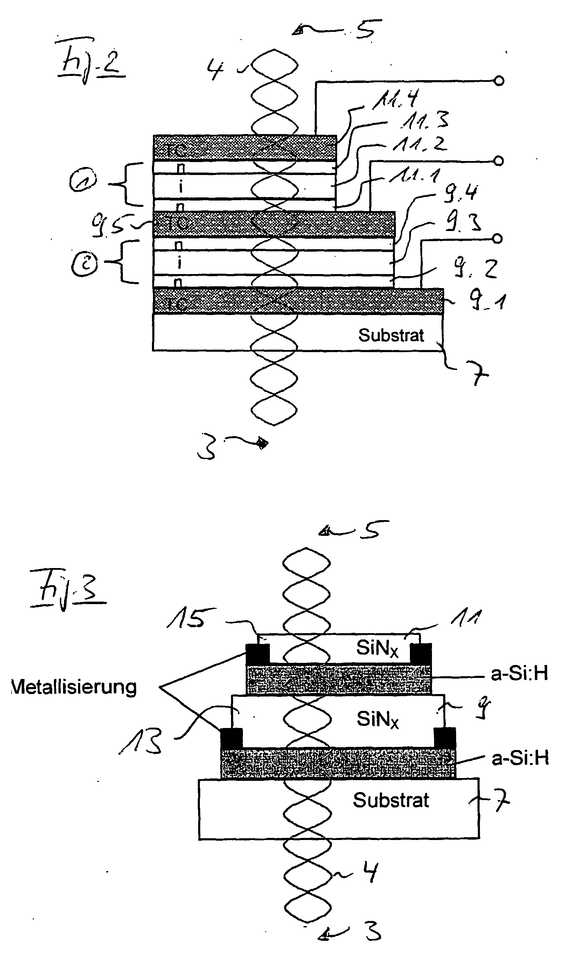

In Figur 2 ist ein Schnitt eines erfindungsgemäßen Photosensors 1 dargestellt, auf den das Diagramm aus Figur 1 anzuwenden ist. Der Photosensor 1 ist zwischen einer Strahlungsquelle 3 und einem Spiegel 5 angeordnet. Die Anordnung erfolgt so, daß die optische Achse eine von der Strahlungsquelle 3 erzeugten stehenden Welle 4 senkrecht durch die Dicke des Photosensors 1 hindurch verläuft und senkrecht auf den Spiegel 5 auftrifft. Der Photosensor 1 umfaßt einen Träger 7, der ein Glassubstrat, ein Quarzsubstrat oder ein Substrat aus Kunststoff sein kann. Für den Fall, daß ein Substrat aus Kunststoff gewählt wird, kann dieses vorzugsweise als Kunststoffolie ausgebildet sein. In der vorliegenden Ausführungsform sind auf dem Träger 7 spiegelseitig, das heißt, auf der der Strahlungsquelle 3 abgewandten Seite des Trägers 7 eine Folge von Halbleiterelementen 9, 11 (Teilsensoren 1 und 2) ausgebildet. Dies muß aber in anderen Ausführungsformen nicht der Fall sein. Der Träger 7 und jedes der Halbleiterelemente 9 und 11 sind im wesentlichen transparent, derart, daß die stehende Welle 4 von der Strahlungsquelle 3 durch den Photosensor 1 hindurch zum Spiegel 5 gelangen kann. Durch Reflexion der stehenden Welle 4 am Spiegel 5 wird in jedem Halbleiterelement 9, 11 in Abhängigkeit des Intensitätsprofils der stehenden Welle 4 ein Photostrom erzeugt.

Das auf dem Träger 7 aufgebrachte Halbleiterelement 9 umfaßt in einer Folge ausgehend vom Träger 7 eine transparente Kontaktschicht 9.1, eine transparente erste n-dotierte Halbleiterschicht 9.2, eine intrinsische zweite Halbleiterschicht 9.3, eine n-dotierte dritte Halbleiterschicht 9.4 und eine zweite transparente Kontaktschicht 9.5. Das zweite Halbleiterelement 11 umfaßt in einer Folge ausgehend von der zweiten Kontaktschicht 9.5 eine transparente erste n-dotierte Halbleiterschicht 11.2, eine intrinsische zweite Halbleiterschicht 11.3, eine n-dotierte dritte Halbleiterschicht 11.4 und eine dritte transparente Kontaktschicht 11.5. Die Kontaktschichten 9.1, 9.5 und 11.5 sowie die erste, zweite und dritte Halbleiterschicht 9.2, 9.3, 9.4 bzw. 11.2, 11.3 und 11.4 sind flächenparallel, in der Reihenfolge jeweils aneinander angrenzend im Halbleiterelement 9 bzw. 11 und quer zur optischen Achse der stehenden Welle 4 angeordnet. Die intrinsischen zweiten Halbleiterschichten 9.3 und 11.3 haben parallel zur Ausbreitungsrichtung der stehenden Welle 4 eine Schichtdicke d von $d_{s1} \leq \lambda/4ns_1$ bzw. $d_{s2} \leq \lambda/4ns_2$ (der Fall $d_{s1} = \frac{\lambda}{4ns_1}$ , $d_{s2} = \frac{\lambda}{4ns_2}$ stellt nur ein Beispiel der und ist nicht Teil der Erfindung), wobei $\lambda$ die Wellenlänge der verwendeten optischen kohärenten Welle und $n_1$ der Brechungsindex der photoelektrisch aktiven zweiten Halbleiterschicht 9.3 und $n_2$ der Brechungsindex der photoelektrisch aktiven zweiten Halbleiterschicht 11.3 ist. Die $ns_2$-dotierten Halbleiterschichten 9.2, 9.4, 11.2 und 11.4 sind im wesentlichen photoelektrisch inaktiv.

Die feste Phasenbeziehung zwischen elektrisch aktiven Halbleiterschichten 9.3, 11.4 des transparenten Photosensors 1 kann hierbei mittels mindestens einer photoelektrisch inaktiven Halbleiterschicht 9.2, 9.4, 11.1, 11.4 aus amorphem, nanokristallinem, mikrokristallinem, polykristallinem oder kristallinem Silizium, Germanium, Kohlenstoff, Stickstoff, Sauerstoff oder aus Legierungen der Materialien erfolgen oder aber aus einem transparenten leitfähigen Oxid, z.B. $S_nO_2$, $Z_nO$, $In_2O_3$ oder $Cd_2SnO_4$, hergestellt sein, welches mit B, Al, In, Sn, Sb oder F dotiert ist. Die Wahl der Halbleiterschicht oder Halbleiterschichten 9.2, 9.4, 11.1, 11.3, mit deren Hilfe die Phasenbeziehung eingestellt wird, hängt von der Wahl der transparenten Photosensors 1 ab. Der Träger 7 ist aus einem Material hergestellt, das z.B. ein Glassubstrat, ein Quarzsubstrat oder ein Substrat aus Kunststoff und insbesondere eine Kunststoffolie sein kann.

In dem Photosensor 1 in Fig. 2 fließt der Photostrom parallel zur Ausbreitungsrichtung der stehenden Welle 4. Als transparente Halbleiterschichten 9.2, 9.3, 9.4 bzw. 11.1, 11.2, 11.3 sind beispielhaft nin-Strukturen eingesetzt, wobei auch andere bekannte Strukturen denkbar sind. Die Phasenbeziehung zwischen den beiden Halbleiterelementen 9 und 11 wird für die zweite Kontaktschicht 9.5 (TCO-Schicht) eingestellt, die gleichzeitig auch als gemeinsamer Kontakt für die beiden Halbleiterelemente 9 -und 11 dient. Zur Bestimmung der Schichtdicke der TCO-Schicht (90°-Phasenbeziehung zwischen den elektrischen Signalen) muß der Einfluß der jeweils halben photoelektrisch aktiven Halbleiterschicht 9.3 bzw. 11.2 und der jeweils dotierten Halbleiterschichten 9.4 bzw. 11.1, welche an der mittleren zweiten transparenten Kontaktfläche 9.5 anliegen, berücksichtigt werden.

Alternativ läßt sich auch eine Struktur realisieren, bei welcher der Photostrom senkrecht zur Ausbreitungsrichtung der stehenden Welle 4 fließt. Ein solcher Photosensor 1 ist in Fig. 3 dargestellt. Hierbei wird als transparenter Photosensor 1 beispielsweise die Photoleitfähigkeit einer amorphen Halbleiterschicht verwendet. Als Kontaktschichten dienen beispielsweise aufgedampfte Aluminiumschichten. Für diese Anordnung ist es nicht erforderlich, daß die Kontaktschichten transparent sind. Zur besseren Kontaktierung können unterhalb der Metallkontakte noch dotierte Bereiche eingebracht oder aufgebracht sein. Die Phasenbeziehung läßt sich in diesem Fall über eine zwischen den beiden Halbleiterelementen 9, 11 aufgebrachte Isolationsschicht 13 einstellen. Beispielhaft ist in Fig. 3 eine Siliziumnitritschicht angedeutet. Diese Schicht isoliert die beiden Halbleiterelemente 9, 11 voneinander und sorgt für eine Phasenbeziehung von 90°. Eine zweite Isolierschicht 15 ist ebenfalls als Siliziumnitritschicht auf das Halbleiterelement 11 aufgebracht und dient der besseren optischen Anpassung des Schichtsystems an die Bedingungen der stehenden Welle 4. Die Verwendung dieser weiteren Halbleiterschichten erlaubt die Optimierung der Schichtstruktur im Hinblick auf eine minimale Reflexion und eine maximale Transmission.

Für die Realisierung eines Halbleitersensors eignet sich im Besonderen amorphes, nanokristallines, mikrokristallines und kristallines Silizium und dessen Legierungen aus mehreren Gründen. So läßt sich amorphes und mikrokristallines Silizum in einem Niedertemperaturprozeß (Depositionstemperatur 200-300°C) mittels plasmaunterstützter Glimmentladung (PECVD Plasma enhanced chemical vapor deposition) auf unterschiedlichen Materialien wie beispielsweise Glas, Quarz oder Kunststoffolie herstellen. Die transparenten und leitfähigen Schichten werden hierbei als Kontaktschichten eingesetzt. Durch die Möglichkeit der Abscheidung dünner amorpher und mikrokristalliner Schichten auf transparenten Substraten bei niedrigen Temperaturen sind diese Schichten sehr gut als Absorbermaterial für einen Halbleitersensor im Durchlichtbetrieb geeignet. So ist es durch gezielte Steuerung der Prozeßparameter während der Herstellung möglich, sehr dünne Schichtsysteme herzustellen.

Die transparenten und elektrisch leitfähigen Schichten (TCO-Schichten) lassen beispielsweise mittels eines CVD-(Chemical Vapor Deposition), Sprüh-Pyrolyse, Verdampfungsverfahren und Sputterverfahren herstellen. Dieser Prozeß ist ebenso wie der PECVD-Prozeß ein Niedertemperaturprozeß.

**Patentansprüche**

1. Photosensor für ein Durchlichtverfahren zur Detektion einer Bewegungsrichtung der Intensitätsmaxima und Intensitätsminima in einem Intensitätsprofil, mit einem transparenten Träger (7), mit zwei dem Träger zugeordneten im wesentlichen transparenten Halbleiterelementen (9, 11) und mit wenigstens einer Kontaktschicht (9.5) oder Isolationsschicht (13), wobei das erste Halbleiterelement (9) über die Kontaktschicht (9.5) oder Isolationsschicht (13) mit dem zweiten Halbleiterelement (11) verbunden ist,
**dadurch gekennzeichnet,**
**daß** das erste Halbleiterelement (9) eine erste transparente photoelektrisch inaktive Halbleiterschicht (9.2, 9.4) und eine erste transparente photoelektrisch aktive Halbleiterschicht (9.3) aufweist und das zweite Halbleiterelement (11) eine erste transparente photoelektrisch inaktive Halbleiterschicht Schicht (11.2, 11.4) eine zweite transparente photoelektrisch aktive Halbleiterschicht (11.3)umfassen und in einer festen Phasenbeziehung zueinander stehen, wobei die erste photoelektrisch aktive Halbleiterschicht (9.3) des ersten Halbleiterelements (9) parallel zur Ausbreitungsrichtung einer außerhalb erzeugten optischen stehenden Welle (4) eine Schichtdicke ds1 von ds1<λ/4ns1 hat und die zweite photoelektrisch aktive Halbleiterschicht (11.3) des zweiten Halbleiterelements (11) parallel zur Ausbreitungsrichtung der stehenden Welle (4) eine Schichtdicke ds2 von ds2<λ/4ns2 hat wobei λ die Wellenlänge der verwendeten optischen kohärenten Welle und ns1, ns2 jeweils der Brechungsindex der photoelektrisch aktiven ersten bzw. zweiten Halbleiterschicht (9.3; 11.2) ist.

2. Photosensor nach Anspruch 1,
**dadurch gekennzeichnet,**

**daß** die feste Phasenbeziehung $K\frac{\lambda}{4} = \sum_{j=1}^{l} djnj + \frac{ds1ns1}{2} + \frac{ds2ns2}{2}$ beträgt, wobei k eine ungerade ganzzahlige Zahl ist, □ die Wellenlänge der verwendeten kohärenten Strahlung ist, I die Anzahl der verwendeten Halbleiterschichten zwischen den aktiven Halbleiterschichten der Halbleiterelemente 1 und 2 (9; 11) ist, $d_{s1}$ die Schichtdicke der photoelektrisch aktiven ersten Halbleiterschichten (9.3), $d_{s2}$ die Schichtdicke der photoelektrisch aktiven zweiten Halbleiterschicht (11.2) ist und $d_1...d_1$ die Schichtdicken der photoelektrisch inaktiven zweiten Halbleiterschichten ist und $n_1...n_1$ der Brechungsindex der im wesentlichen photoelektrisch inaktiven ersten Halbleiterschichten (9.2, 9.4; 11.1, 11.3) ist und $ns_1$ der Brechungsindex der photoelektrisch aktiven ersten Halbleiterschicht und $ns_2$ der Brechungsindex der photoelektrisch aktiven zweiten Halbleiterschicht.

3. Photosensor nach Anspruch 1 oder 2,
**dadurch gekennzeichnet,**
**daß** die Halbleiterbauelemente als Photoleiter, Schottdydioden oder als pin-, nip-, pip-, nin-, npin-, pnip-, pinp-, nipn-Struktur oder aus Kombinationen der Strukturen realisiert werden, wobei der Ladungstrasport innerhalb der transparenten Photosensoren sowohl parallel als auch senkrecht zur Ausbreitungsrichtung der stehenden Welle erfolgen kann.

4. Photosensor nach einem der vorstehenden Ansprüche,
**dadurch gekennzeichnet,**
**daß** der transparente Träger (7) auf welchem das erste Halbleiterelement (9) aufgebracht ist, transparent für die kohärente Strahlung der Wellenlänge λ ist.

5. Photosensor nach einem der Ansprüche 1 bis 4,
**dadurch gekennzeichnet,**
**daß** wenigstens eine der Halbleiterschichten (9.2, 9.3, 9.4; 11.1, 11.2, 11.3) aus einem Material ausgebildet ist, ausgewählt aus der Gruppe bestehend aus amorphem Material, mikrokristallinem Material, polykristallinem Material, kristallinem Material.

6. Photosensor nach einem der Ansprüche 1 bis 5,
**dadurch gekennzeichnet,**
**daß** wenigstens eine der Halbleiterschichten (9.2, 9.3, 9.4; 11.1, 11.2, 11.3) aus einem Material ausgebildet ist, ausgewählt aus der Gruppe bestehend aus Silizium, Germanium, Kohlenstoff, Sauerstoff, Stickstoff, einer Legierung dieser Materialien, transparenten leitfähigen Oxiden, dünner Metallfilm.

7. Photosensor nach einem der vorstehenden Ansprüche,
**dadurch gekennzeichnet,**
**daß** der transparente Träger (7) aus einem Material ausgebildet ist, ausgewählt aus der Gruppe bestehend aus Glas, Quarz, Kunststoffolie.

8. Photosensor nach einem der vorstehenden Ansprüche,
**dadurch gekennzeichnet,**
**daß** jede Kontaktschicht (9.1, 9.5; 11.4) aus einem Material ausgebildet ist, ausgewählt aus der Gruppe bestehend aus $NO_2$, $ZnO$, $In_2O_3$, $Cd_2SnO_4$, welche mit einem Element ausgewählt aus der Gruppe bestehend aus B, Al, In, Sn, Sb, F dotiert sind, dünnen Metallfilmen, halbleitenden Schichten.

9. Photosensor nach einem der vorstehenden Ansprüche,
**dadurch gekennzeichnet,**
**daß** eine Schicht zur optischen Anpassung jedes Halbleiterelements (9) auf diesem ausgebildet ist.

10. Photosensor nach einem der vorstehenden Ansprüche,
**dadurch gekennzeichnet,**
**daß** dieser als ein- oder zweidimensionales Sensorfeld ausgebildet ist.

**Claims**

1. A photosensor for a transmitted light method for detecting a direction of motion of the intensity maxima and intensity minima in an intensity profile, comprising a transparent support (7), comprising two substantially transparent semiconductor elements (9, 11) associated with the support and comprising at least one contact layer (8.5) or insulation layer (13), wherein the first semiconductor element (9) is connected to the second semiconductor element (11) via the contact layer (9.5) or insulation layer (13), **characterised in that** the first semiconductor element (9) comprises a first transparent photoelectrically inactive semiconductor layer (9.2, 9.4) and a first transparent photoelectrically active semiconductor layer (9.3) and the second semiconductor element (11) comprises a second transparent photoelectrically inactive semiconductor layer (11.2, 11.4) and a second transparent photoelectrically active semiconductor layer (11.3) and are in a fixed phase relationship to each other, wherein the first photoelectrically active semiconductor layer (9.3) of the first semiconductor element (9) has a layer thickness ds1 of ds1 < λ/4ns1 parallel to the direction of propagation of an externally generated optical standing wave (4) and the second photoelectrically active semiconductor layer (11.3) of the first semiconductor element (11) has a layer thickness ds2 of ds2 < λ/4ns2 parallel to the direction of propagation of an externally generated optical standing wave (4), wherein λ is the wavelength of the optical coherent wave used and ns1, ns2 is the refractive index of the photoelectrically active first or second semiconductor layer (9.3; 11.2) respectively.

2. The photosensor according to claim 1, **characterised in that** the fixed phase relationship is

$$K\frac{\lambda}{4} = \sum_{j=1}^{l} djnj + \frac{ds1ns1}{2} + \frac{ds2ns2}{2}$$ where k is an odd integer value, λ is the wavelength of the coherent radiation used, 1 is the number of semiconductor layers used between the active semiconductor layers of the semiconductor elements 1 and 2 (9; 11), $d_{s1}$ is the layer thickness of the photoelectrically active first semiconductor layers (9.3), $d_{s2}$ is the layer thickness of the photoelectrically active second semiconductor layer (11.2) and $d_1...d_1$ are the layer thicknesses of the photoelectrically inactive second semiconductor layers and $n_1...n_1$ is the refractive index of the substantially photoelectrically inactive first semiconductor layers (9.2, 9.4; 11.1, 11.3) and $ns_1$ is the refractive index of the photoelectrically active first semiconductor layer and $n_{s2}$ is the refractive index of the photoelectrically active second semiconductor layer.

3. The photosensor according to claim 1 or 2, **characterised in that** the semiconductor elements are implemented as photoconductors, Schottky diodes or as pin, nip, pip, nin, npin,pnip, pinp, nipn structures or as combinations of the structures, wherein the charge transport inside the transparent photosensors can take place both parallel and perpendicular to the direction of propagation of the standing wave.

4. The photosensor according to any one of the preceding claims, **characterised in that** the transparent support (7) on which the first semiconductor element (9) is applied is transparent for coherent radiation of wavelength λ.

5. The photosensor according to any one of claims 1 to 4, **characterised in that** at least one of the semiconductor layers (9.2, 9.3, 9.4; 11.1, 11.2, 11.3) is made of a material selected from the group consisting of amorphous material, microcrystalline material, polycrystalline material, crystalline material.

6. The photosensor according to any one of claims 1 to 5, **characterised in that** at least one of the semiconductor layers (9.2, 9.3, 9.4; 11.1, 11.2, 11.3) is made of a material selected from the group consisting of silicon, germanium, carbon, oxygen, nitrogen, an alloy of these materials, transparent conductive oxides, thin metal film.

7. The photosensor according to any one of the preceding claims, **characterised in that** the transparent support (7) is formed of a material selected from the group consisting of glass, quartz, plastic film.

8. The photosensor according to any one of the preceding claims, **characterised in that** each contact layer (9.1, 9.5; 11.4) is formed from a material selected from the group consisting of $NO_2$, ZnO, $In_2O_3$, $Cd_2SnO_4$ which are doped with an element selected from the group consisting of B, Al, In, Sn, Sb, F, thin metal films, semiconducting layers.

9. The photosensor according to any one of the preceding claims, **characterised in that** one layer for optical matching of each semiconductor element (9) is formed thereon.

10. The photosensor according to any one of the preceding claims, **characterised in that** this is configured as a one- or two-dimensional sensor array.

**Revendications**

1. Détecteur optique pour procédé de détection par transparence d'un sens de mouvement des maxima d'intensité et des minima d'intensité dans un profil d'intensité, comportant un support transparent (7), deux éléments semi-conducteurs sensiblement transparents (9, 11) et au moins une couche de contraste (9.5) ou une couche isolante (13), le premier élément semi-conducteur (9) étant raccordé par la couche de contact (9.5) ou la couche isolante (163) au deuxième élément semi-conducteur (11),
**caractérisé en ce que**
le premier élément semi-conducteur (9) comprend une première couche semi-conductrice transparente inactive au niveau photoélectrique (9.2, 9.4) et une première couche semi-conductrice transparente active au niveau photoélectrique (9.3) et que le deuxième élément semi-conducteur (11) comprend une première couche transparente inactive au niveau photoélectrique (11.2, 11.4) et une deuxième couche semi-conductrice transparente active au niveau photoélectrique (11.3) et qu'ils sont mutuellement en relation de phase solide, la première couche semi-conductrice active au niveau photoélectrique (9.3) du premier élément semi-conducteur (9) ayant, parallèlement au sens de diffusion d'une onde optique verticale (4) générée à l'extérieur, une épaisseur de couche ds1 de ds1 < λ4ns1 et la deuxième couche semi-conductrice active au niveau photoélectrique (11.3) du deuxième élément semi-conducteur (11) ayant, parallèlement au sens de diffusion de l'onde optique verticale (4), une épaisseur de couche ds2 de ds2 < λ4ns2, la longueur d'onde de l'onde optique cohérente utilisée et ns1, ns2 étant respectivement l'indice de réfraction de la première ou de la deuxième couche active au niveau photoélectrique (9.3 ; 11.2).

2. Détecteur optique selon la revendication 1,
**caractérisé en ce que**

la relation de phase solide s'élève à $K\dfrac{\lambda}{4} = \displaystyle\sum_{j=1}^{l} djnj + \dfrac{ds1ns1}{2} + \dfrac{ds2ns2}{2}$, k étant un nombre entier impair, λ étant la longueur d'onde du rayonnement cohérent employé, 1 étant le nombre de couches semi-conductrices utilisées entre les couches semi-conductrices actives des éléments semi-conducteurs 1 et 2 (9 ; 11), $d_{s1}$ étant l'épaisseur de couche de la première couche semi-conductrice active au niveau photoélectrique (9.3), $d_{s2}$ étant l'épaisseur de couche de la deuxième couche semi-conductrice active au niveau photoélectrique (9.2) et $d_1...d_1$ les épaisseurs de couche des deuxièmes couches semi-conductrices inactives au niveau photoélectrique et $n_1...n_1$ étant l'indice de réfraction des premières couches semi-conductrices sensiblement inactives au niveau photoélectrique (9.2, 9.4 ; 11.1, 11.3 et $n_{s1}$ étant l'indice de réfraction de la première couche semi-conductrice active au niveau photoélectrique et $ns_2$ étant l'indice de réfraction de la deuxième couche semi-conductrice active au niveau photoélectrique.

3. Détecteur optique selon la revendication 1 ou 2,
**caractérisé en ce que**
les éléments de construction semi-conducteurs sont réalisés sous forme de photoconducteurs, diodes Schottdy ou d'une structure pin, nip, pip, nin, npin, pnip, pinp, nipn ou de combinaisons de ces structures, le transport de charge au sein des capteurs optiques transparents pouvant avoir lieu aussi bien parallèlement que perpendiculairement au sens de diffusion de l'onde verticale.

4. Détecteur optique selon une des revendications précédentes,
**caractérisé en ce que**
le support transparent (7) sur lequel le premier élément semi-conducteur (9) est installé est transparent au rayonnement cohérent de la longueur d'onde.

5. Détecteur optique selon une des revendications 1 à 4,
**caractérisé en ce que**
au moins une des couches semi-conductrices (9.2, 9.3, 9.4 ; 11.1, 11.2, 11.3) est constituée d'un matériau sélectionné parmi le groupe composé de matériau amorphe, de matériau microcristallin, de matériau polycristallin, de matériau cristallin.

6. Détecteur optique selon une des revendications 1 à 5,
**caractérisé en ce que**
au moins une des couches semi-conductrices (9.2, 9.3, 9.4 ; 11.1, 11.2, 11.3) est constituée d'un matériau sélectionné parmi le groupe composé de silicium, germanium, carbone, oxygène, azote, alliage de ces matériaux, oxyde conducteur transparent, film métallique mince.

7. Détecteur optique selon une des revendications précédentes,
**caractérisé en ce que**
le support transparent (7) est constitué d'un matériau sélectionné parmi le groupe composé de verre, quartz, film de matière plastique.

8. Détecteur optique selon une des revendications précédentes,
**caractérisé en ce que**
chaque couche de contact (9.1, 9.5 ; 11.4) est constituée d'un matériau sélectionné parmi le groupe composé de $NO_2$, ZnO, $In_2O_3$, $Cd_2SnO_4$, qui sont dopés avec un élément sélectionné parmi le groupe composé de B, Al, In, Sn, Sb, F, films métalliques minces, couches semi-conductrices.

9. Détecteur optique selon une des revendications précédentes,

**caractérisé en ce que**
une couche destinée à l'adaptation optique de chaque élément semi-conducteur (9) est constituée sur celui-ci.

10. Détecteur optique selon une des revendications précédentes,
   **caractérisé en ce que**
   celui-ci est réalisé sous forme d'un champ de captage uni- ou bidimensionnel.

# Fig. 1

$$d_{s1} \leq \frac{\lambda}{4n_{s1}}$$

$$d_{s2} \leq \frac{\lambda}{4n_{s2}}$$

$$k\frac{\lambda}{8} = \sum_{j=1}^{l} d_j n_j + \frac{d_{s1}n_{s1}}{2} + \frac{d_{s2}n_{s2}}{2}$$

Fig. 2

Fig. 3

Metallisierung

SiN$_x$

a-Si:H

SiN$_x$

a-Si:H

Substrat

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3300369
- US 4443107 A
- DE 3612221
- US 6013912 A
- US 4441789 A